# EUROPEAN PATENT APPLICATION

(11) **EP 3 200 564 A1**
(43) Date of publication of application: **02.08.2017**
(21) Application number: 15844974.4
(22) Date of filing: 09.07.2015
(51) Int. Cl.: H05B 37/02, F21V 19/00, H01L 33/00

(54) **LIGHTING DEVICE**

(30) Priority: 26.09.2014 JP 2014196493
(71) Applicant: Sharp Kabushiki Kaisha, Sakai City, Osaka 590-8522 (JP)
(72) Inventor: SUMITANI Ken, Sakai City Osaka 590-8522 (JP)
(74) Representative: Treeby, Philip David William
(86) International application number: PCT/JP2015/069785
(87) International publication number: WO 2016/047242

(57) **Abstract**

A lighting device having: a first light source including at least one first light-emitting unit having a first light emission color; a second light source including at least one second light-emitting unit having a second light emission color; a resistor connected in series to the first light source; and a switching element connected in series to the second light source, current flowing to the first light source being converted into a control voltage by the resistor, and current flowing to the switching element being controlled by the control voltage.

## Description

### Technical Field

The present invention relates to a lighting device.

### Background Art

As a light source used for lighting devices, the proportion that LEDs (light-emitting diodes) account for has grown dramatically in recent years, replacing conventionally used incandescent lights and fluorescent lights. An LED package that emits a white color is often used for lighting devices that use LEDs. A white light-emitting LED package, in which an LED element that emits blue light and a phosphor that converts blue light into light of a longer wavelength (a yellow color, green color, red color, or the like) are packaged, is a common method for realizing the emission of a white color by combining said colors. Despite being referred to as the same white color, the light emission colors from LED packages differ depending on the amount of the blue color that is output and the type, amount, and the like of the phosphor. Lighting devices provided with a toning function have also come to be widely used, in which the toning function adjusts the color temperature of illumination light by combining an LED package that emits a white color of a high color temperature and an LED package that emits a white color of a low color temperature, and controlling the ratio of the light emission amounts thereof. Furthermore, LED lighting devices provided with a dimming function have also come to be widely used, in which the dimming function is able to adjust the illuminance of illumination light by utilizing the characteristics of LEDs that are capable of changing light emission intensity easily by means of the current amount.

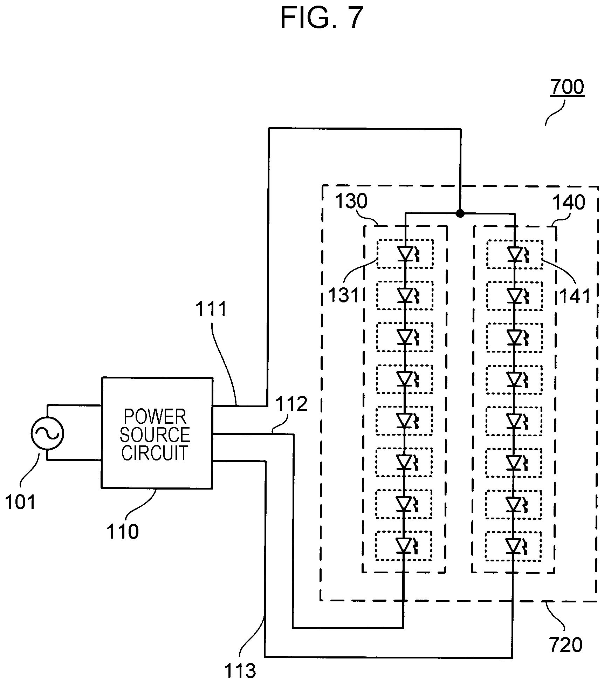

A method for realizing an LED lighting device provided with a dimming function and a toning function by means of a simple conventional scheme will be described using Fig. 7. An LED lighting device 700 depicted in Fig. 7 has an alternating-current power source 101 as an input power source, and drives LED light sources of two different kinds of color temperatures. An irradiation unit 720 is provided with an LED light source 130 made up of a plurality of LED packages 131 that emit light of a first color temperature, and an LED light source 140 made up of a plurality of LED packages 141 that emit light of a second color temperature. A power source circuit 110 that generates a direct-current voltage for driving LEDs from the alternating-current power source is able to drive the LED light source 130 and the LED light source 140 separately by using an anode line 111, a cathode line 112, and a cathode line 113. The LED lighting device 700 is provided with a means for controlling some kind of dimming and toning, although not especially depicted, and realizes dimming and toning by altering the current that drives the irradiation unit 720.

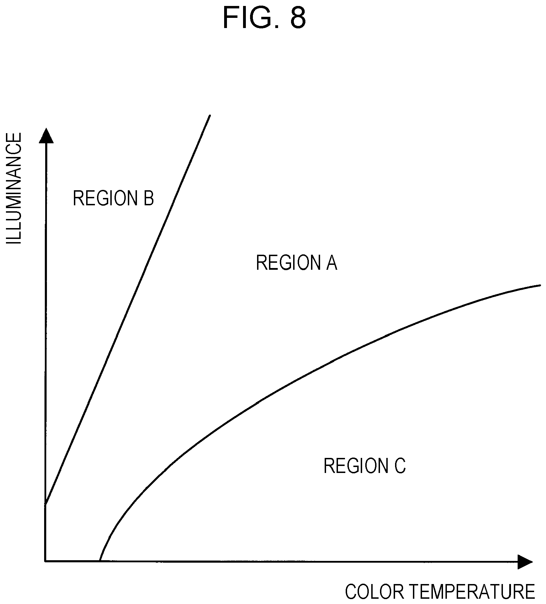

It is not necessarily desirable to be able to freely set dimming and toning independently. The illumination color and illuminance perceived by the human senses as being pleasing is said to be within a specific range, which will be described using Fig. 8. Fig. 8 is a graph that is referred to as a Kruithof curve, in which region A is a region that is perceived by people as being pleasing (the so-called "Kruithof pleasing region"). For example, if the illuminance is too strong (the upper side of the graph) with a strongly reddish illumination light (low color temperature, the left side of the graph) (region B), there is a tendency to receive an impression of sweltering heat and an unpleasant feeling. Furthermore, if the illuminance is too weak (the lower side of the graph) with strongly bluish illumination light (high color temperature, the right side of the graph) (region C), there is a tendency to receive a gloomy impression and an unpleasant feeling. If it is made possible for the illumination color and illuminance to be freely adjusted within a certain range, an unpleasant setting may be unintentionally implemented. Hence, technology is being developed with which the color temperature of the light emission color is made to change automatically in accordance with illuminance so as to result in a region that feels pleasing.

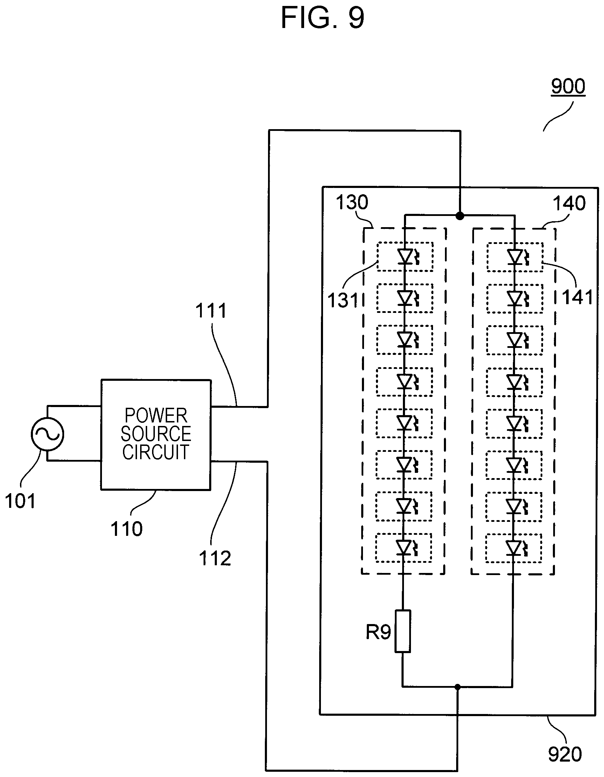

An LED lighting device 900 based upon this line of thinking is depicted in Fig. 9. In the technology disclosed in PTL 1, a resistor is added to one of the single LEDs connected in parallel; however, in the LED lighting device 900 depicted in Fig. 9, in order to compare with other configurations mentioned later on, two LED light sources formed by connecting eight LEDs in series are connected in parallel, and a resistor R9 is connected to only one of the LED light sources.

The differences between the LED lighting device 900 and the LED lighting device 700 will be described. Similar to the irradiation unit 720 provided in the LED lighting device 700, an irradiation unit 920 provided in the LED lighting device 900 has the LED light source 130 made up of the plurality of LED packages 131 that emit light of the first color temperature, and the LED light source 140 made up of the plurality of LED packages 141 that emit light of the second color temperature. Here, it is selected that the first color temperature emitted by the LED packages 131 is lower than the second color temperature emitted by the LED packages 141. The resistor R9 is connected in series to the LED light source 130. Furthermore, although the irradiation unit 720 was separately provided with the cathode line 112 for driving the LED light source 130 and the cathode line 113 for driving the LED light source 140, the irradiation unit 920 is provided with only a common cathode line 112.

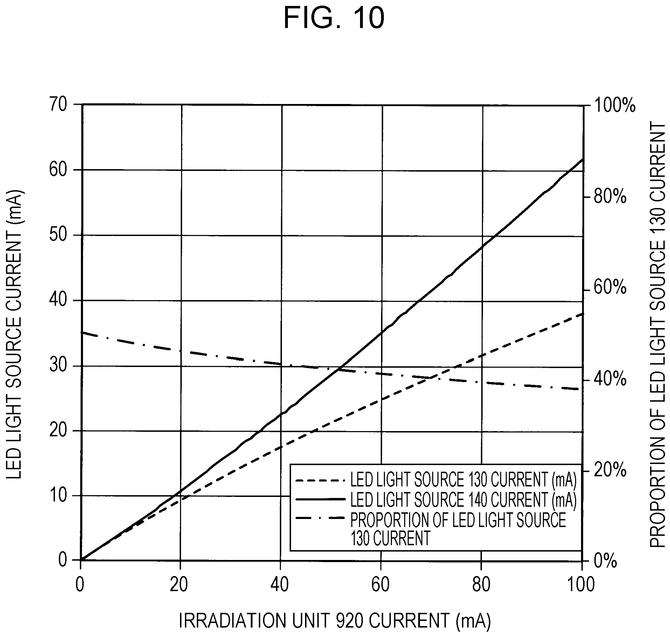

Simulation results calculated from the configuration of the irradiation unit 920 are depicted in Fig. 10. In this simulation, the current flowing to the anode line 111 and the cathode line 112 changes, and the current flowing to the LED light source 130, the current flowing to the LED light source 140, and the ratio of the current flowing to the LED light source 130 are calculated. It should be noted that the resistance value of the resistor R9 is adjusted in such a way that effects are easily understood. The horizontal axis of Fig. 10 indicates the current flowing to the irradiation unit 920, whereas the vertical axes indicate the current flowing to each LED light source and the proportion of the current flowing to the LED light source 130 out of the current flowing to the irradiation unit 920.

When the current flowing to the irradiation unit 920 is small, the current flowing to the resistor R9 is also small. A voltage drop caused by the resistor R9 is the product of the resistance value of the resistor R9 and the value of the current flowing to the resistor R9, and therefore when the current flowing to the resistor R9 is small, this voltage drop is also small. Consequently, whether or not the resistor R9 is present has little effect, and the LED light source 130 and the LED light source 140 pass the same level of current as long as they have the same level of forward voltage. When the current flowing to the irradiation unit 920 is increased from this level, the current flowing to the resistor R9 increases accordingly, and the voltage drop caused by the resistor R9 increases. For that reason, the voltage applied between the anode line 111 and cathode line 112 of the LED light source 130 decreases, and it becomes less likely for current to flow to the LED light source 130. In other words, as the current flowing to the irradiation unit 920 increases, the current flowing to the LED light source 130 decreases compared to the LED light source 140. Consequently, the proportion of the current of the LED light source 130 out of the current of the irradiation unit 920 decreases. The LED light source 130 has irradiation light of a low color temperature and the LED light source 140 has irradiation light of a high color temperature, and therefore, as the current flowing to the irradiation unit 920 increases, irradiation at a high color temperature is obtained overall. Owing to these characteristics, it is possible to keep the light emission color within the Kruithof pleasing region (region A in Fig. 8).

Owing to the aforementioned configuration, it is possible for the LED lighting device 900 to cause the color temperature of the light emission color to change automatically in accordance with illuminance. In addition, it is also possible, at the same time, to simplify control of the irradiation unit from the power source circuit into one system rather than two systems.

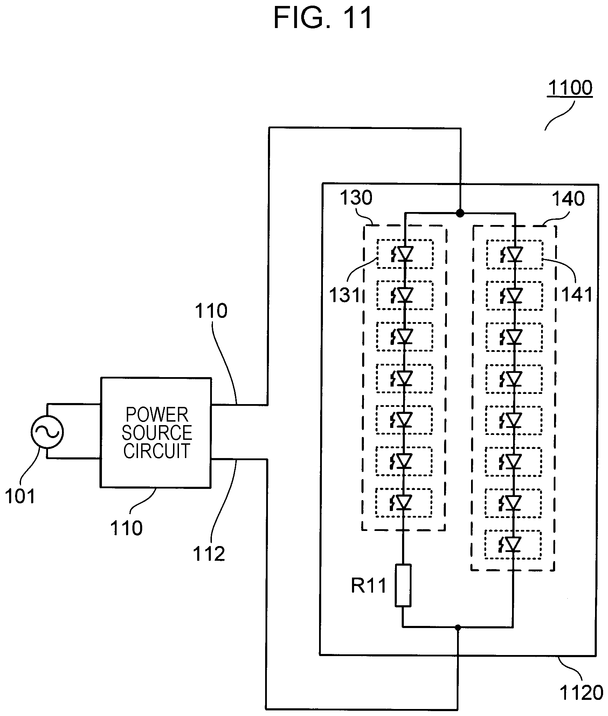

Fig. 11 depicts another configuration of a lighting device in which the color temperature of the light emission color is made to change automatically in accordance with illuminance. The difference between an LED lighting device 1100 depicted in Fig. 11 and the LED lighting device 900 is that, in an irradiation unit 1120 of the LED lighting device 1100, the LED light source 130 and the LED light source 140 have different quantities of LED packages. In this example, the LED light source 130 has seven LED packages 131 connected in series, and the LED light source 140 has eight LED packages 141 connected in series. Therefore, the forward voltage of the LED light source 130 is smaller by an amount proportionate to one LED package when compared to the forward voltage of the LED light source 140.

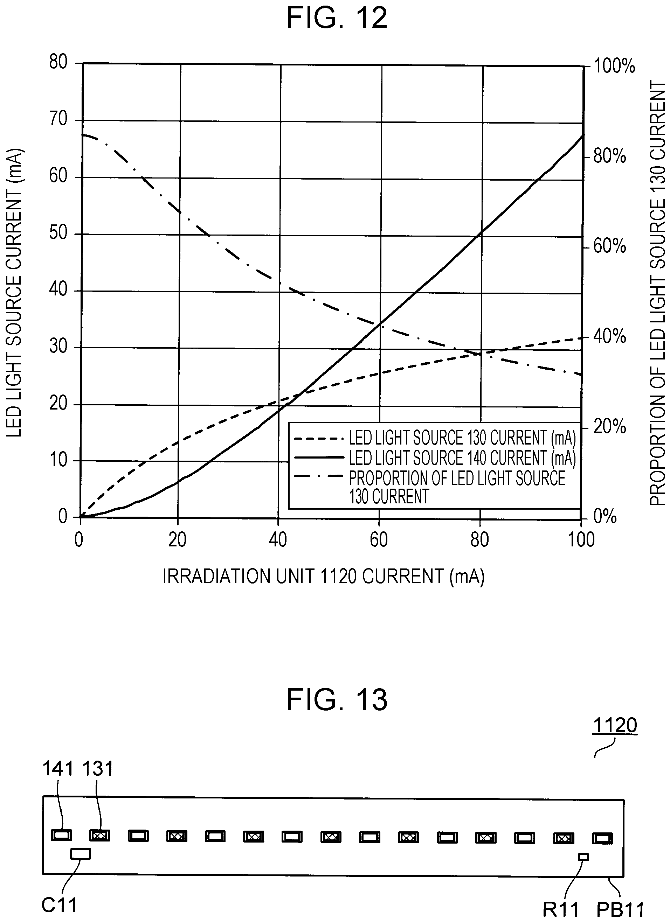

Simulation results calculated from the configuration of the irradiation unit 1120 of the LED lighting device 1100 are depicted in Fig. 12. The notation method for this graph is similar to that for Fig. 10. The resistance value of a resistor R11 connected to the LED light source 130 is adjusted in such a way that effects are easily understood.

When the current flowing to the irradiation unit 1120 is small, the voltage drop of the resistor R11 is small, and therefore whether or not the resistor R11 is present has little effect. Consequently, a large amount of current flows to the LED light source 130, which has a lower forward voltage than the LED light source 140. As the current of the irradiation unit 1120 increases, the voltage drop of the resistor R11 increases, and therefore the current flowing to the LED light source 140 becomes gradually closer to the current flowing to the LED light source 130. At the level at which the voltage drop of the resistor R11 and the difference in forward voltage coincides, the current flowing to each of the LED light sources 130 and 140 becomes equal. Thereafter, the voltage drop of the resistor R11 further increases and therefore the ratio of the current reverses, and the LED light source 140 passes more current than the LED light source 130.

With the configuration of the LED lighting device 1100, it is possible to ensure a greater difference in current than with the LED lighting device 900. In other words, it is possible to increase the change in color temperature.

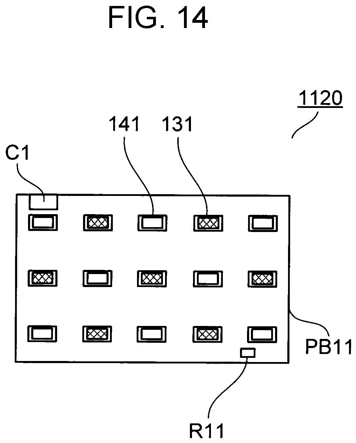

An example of an LED substrate in which the irradiation unit 1120 is incorporated into a single printed substrate will be described using the schematic diagrams of Figs. 13 and 14. Fig. 13 is an LED substrate in which seven LED packages 131 (the hatched sections in the drawing), eight LED packages 141 (the unhatched sections in the drawing), the resistor R11, and a connector C11 are mounted on a printed substrate PB11. The LED packages 131 and the LED packages 141 are mounted equally in an alternating manner, and therefore color irregularities and luminance irregularities can be suppressed to the minimum. Furthermore, the work for connecting an anode and cathode can be easily performed by merely inserting a harness into the connector C11.

The LED substrate depicted in Fig. 14 also has a configuration similar to that in Fig. 13; however, the LED packages 131 and the LED packages 141 are arranged in a staggered manner. Thus, surface irradiation is possible with a single substrate, and color irregularities can be suppressed to the minimum by implementing an equally staggered arrangement.

As mentioned above, conventionally, with a simple configuration, it has been possible to realize a lighting device in which the color temperature of the light emission color is made to change automatically in accordance with illuminance.

### Citation List

### Patent Literature

PTL 1: Japanese Unexamined Patent Application Publication No. 2011-222723.

### Summary of Invention

### Technical Problem

In the method described for the LED lighting device 900 based upon the technology disclosed in PTL 1, it was difficult to increase the difference in the light emission amounts of light sources of two colors. Although the difference in current increases if the resistance value of an added resistor is increased, the light emission amount of the light source to which the resistor is added decreases.

In the method described for the LED lighting device 1100, there is a limitation to the quantity of the LED packages. With the LED substrates depicted in Figs. 13 and 14, LED packages of two kinds of light emission colors are arranged equally in a single unit, and therefore color irregularities are unlikely to occur. However, when a long linear light source is to be realized with a plurality of LED substrates depicted in Fig. 13 being arranged horizontally side-by-side, the LED packages having the greater quantity (the LED packages 141) are adjacent to each other at the boundaries between adjacent substrates, and therefore color irregularities occur. Similarly, it is not possible for the LED substrate depicted in Fig. 14 to be arranged vertically and horizontally in an equal manner so that the same colors are not adjacent. In this way, considerable restrictions are imposed on the quantity and arrangement of the LED packages.

The present invention takes the aforementioned situations into consideration, and aims to provide a lighting device in which it is possible to cause the color temperature of the light emission color to change automatically in accordance with illuminance with a simple configuration, and a high degree of freedom is obtained in terms of the quantity and arrangement of light-emitting units (for example, LED packages).

### Solution to Problem

In order to achieve the aforementioned aim, a lighting device according to an aspect of the present invention has a configuration having: a first light source including at least one first light-emitting unit having a first light emission color; a second light source including at least one second light-emitting unit having a second light emission color; a resistor connected in series to the first light source; and a switching element connected in series to the second light source, current flowing to the first light source being converted into a control voltage by the resistor, and current flowing to the switching element being controlled by the control voltage (first configuration).

Furthermore, in the first configuration, it is preferable that a field-effect transistor be used as the switching element (second configuration).

Furthermore, in the first or second configuration, it is preferable that the first light source, the second light source, the resistor, and the switching element be mounted on the same printed substrate (third configuration).

Furthermore, in any of the first to third configurations, it is preferable that a plurality of irradiation units including the first light source, the second light source, the resistor, and the switching element be connected in series or parallel (fourth configuration).

Furthermore, in order to achieve the aforementioned aim, a lighting device according to another aspect of the present invention has a configuration having: a first light source including at least one first light-emitting unit having a first light emission color; a second light source including at least one second light-emitting unit having a second light emission color; and a resistor connected in series to the first light source, the first light-emitting unit and the second light-emitting unit being formed by different quantities of light-emitting elements being connected in series.

### Advantageous Effects of Invention

According to the present invention, it is possible to cause the color temperature of the light emission color to change automatically in accordance with illuminance with a simple configuration, and a high degree of freedom is obtained in terms of the quantity and arrangement of light-emitting units (for example, LED packages).

### Brief Description of Drawings

[Fig. 1] Fig. 1 is a diagram depicting a configuration of a lighting device according to a first embodiment of the present invention.
[Fig. 2] Fig. 2 is a graph depicting simulation results for the lighting device according to the first embodiment of the present invention.
[Fig. 3] Fig. 3 is a drawing depicting a configuration of a lighting device according to a second embodiment of the present invention.
[Fig. 4] Fig. 4 is a drawing depicting a configuration of a lighting device according to a third embodiment of the present invention.
[Fig. 5] Fig. 5 is a drawing depicting a schematic configuration of an LED substrate according to a fourth embodiment of the present invention.
[Fig. 6] Fig. 6 is a drawing depicting another example of a schematic configuration of the LED substrate according to the fourth embodiment of the present invention.
[Fig. 7] Fig. 7 is a drawing depicting a configuration of a lighting device according to a first conventional example.
[Fig. 8] Fig. 8 is a schematic graph depicting a Kruithof curve.
[Fig. 9] Fig. 9 is a drawing depicting a configuration of a lighting device according to a second conventional example.
[Fig. 10] Fig. 10 is a graph depicting simulation results for the lighting device according to the second conventional example.
[Fig. 11] Fig. 11 is a drawing depicting a configuration of a lighting device according to a third conventional example.
[Fig. 12] Fig. 12 is a graph depicting simulation results for the lighting device according to the third conventional example.
[Fig. 13] Fig. 13 is a drawing depicting a schematic configuration of an LED substrate according to a conventional example.
[Fig. 14] Fig. 14 is a drawing depicting a schematic configuration of an LED substrate according to a conventional example.
[Fig. 15] Fig. 15 is a drawing depicting a configuration of a lighting device according to a fifth embodiment of the present invention.
[Fig. 16A] Fig. 16A is a graph depicting simulation results for the lighting device according to the fifth embodiment of the present invention.
[Fig. 16B] Fig. 16B is a graph depicting simulation results for the lighting device according to the fifth embodiment of the present invention.

### Description of Embodiments

Hereinafter, embodiments of the present invention will be described with reference to the drawings.

### <First Embodiment>

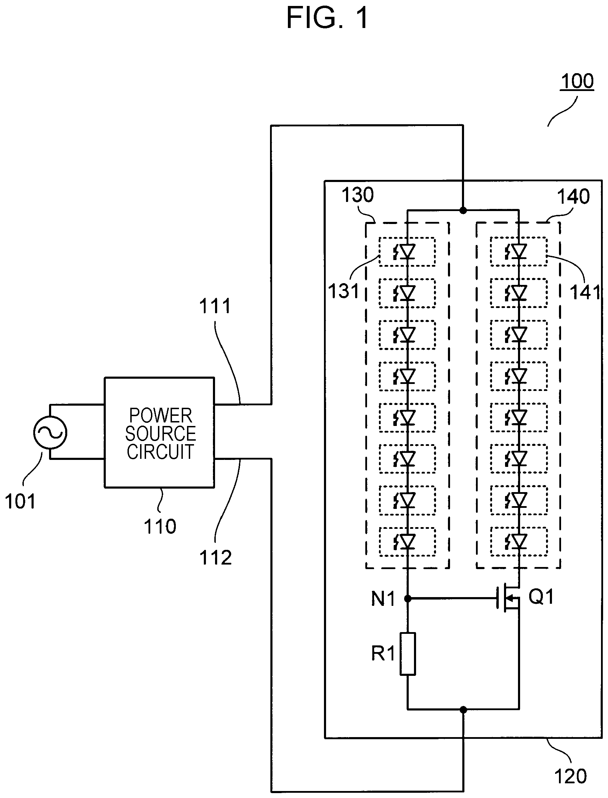

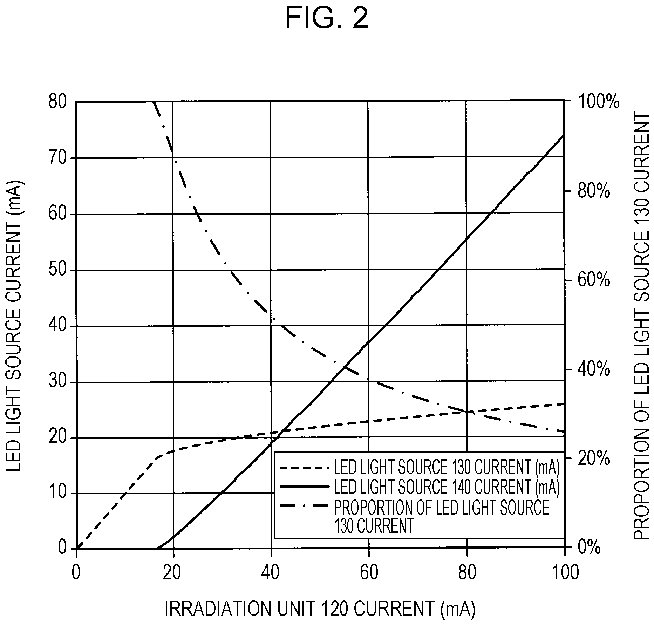

An LED lighting device according to a first embodiment of the present invention will be described using Figs. 1 and 2.

An LED lighting device 100 according to the present embodiment depicted in Fig. 1 is a lighting device that operates with an alternating-current power source 101 as a power source. The LED lighting device 100 has a power source circuit 110 that generates a direct-current voltage for driving LEDs from the alternating-current power source 101, and an irradiation unit 120 that is provided with the LEDs.

The power source circuit 110 drives the irradiation unit 120 and causes light to be emitted using an anode line 111 and a cathode line 112. Although not especially depicted, some kind of dimming function is provided in the power source circuit 110, and the current that drives the irradiation unit 120 can be controlled.

The irradiation unit 120 has: an LED light source 130 formed by a plurality of LED packages (an example of a light-emitting unit) 131 that have a first light emission color being connected in series; a second LED light source 140 formed by a plurality of LED packages 141 that have a second light emission color being connected in series; a switching element Q1 that is an N-channel MOS-FET (field-effect transistor); and a resistor R1.

A connection point where the anode sides of each of the LED light source 130 and the LED light source 140 are connected is connected to the anode line 111. The cathode side of the LED light source 130 is connected to one end of the resistor R1. The cathode side of the LED light source 140 is connected to the drain of the switching element Q1. A node N1 that is a connection point between the LED light source 130 and the resistor R1 is connected to the gate of the switching element Q1. A connection point between the other end of the resistor R1 and the source of the switching element Q1 is connected to the cathode line 112.

The operation when the driving current of the irradiation unit 120 is changed will be described.

The current that flows to the LED light source 130 and the current that flows to the resistor R1 are substantially equal. Furthermore, the current that flows to the LED light source 140 and the current that flows to the switching element Q1 are substantially equal. Thus, the current that flows to the irradiation unit 120 becomes the sum of the current that flows to the LED light source 130 and the current that flows to the LED light source 140.

When the current that flows to the irradiation unit 120 is small, the current that flows to the LED light source 130 and the current that flows to the LED light source 140 are both small. The current that flows to the resistor R1 is also small, and therefore there is almost no difference between the potential of the node N1 and the potential of the cathode line 112. The switching element Q1 is an N-channel MOS-FET having the gate connected to the node N1, and therefore almost no current can be passed in a state in which the voltage between the gate and source is small. Consequently, almost no current is passed to the LED light source 140, whereas current flows to the LED light source 130.

From here, when the current that flows to the irradiation unit 120, in other words, the current that flows to the LED light source 130, is increased, the current that flows to the resistor R1 increases, and the voltage between the node N1 and the cathode line 112 increases in proportion thereto. When this voltage increases to a certain extent and reaches a voltage at which the switching element Q1 turns on, the switching element Q1 passes current. In other words, current flows not only to the LED light source 130 but also to the LED light source 140.

1 Generally, the on-resistance of a MOS-FET is extremely small, and therefore, when the current that flows to the irradiation unit 120 is additionally increased in a state in which the switching element Q1 is on, the current that flows to the LED light source 140 can be increased compared to the LED light source 130.

Summarizing the above explanation, when the current that flows to the irradiation unit 120 is small, in other words, when the illuminance of the emitted light is low, only the LED light source 130 emits light; however, when the current increases, in other words, as the illuminance of the emitted light increases, it becomes possible for the LED light source 140 to also emit light, and the proportion of current that flows to the LED light source 140 gradually increases. In the case where the LED light source 130 is a white light source having a low color temperature and the LED light source 140 is a white light source having a high color temperature, an operation results in which light is emitted at a low color temperature when the illuminance is low, and light is gradually emitted at a high color temperature as the illuminance increases.

Simulation results calculated from the configuration of the irradiation unit 120 of the LED lighting device 100 are depicted in Fig. 2. The notation method for this graph is similar to the previous Fig. 10. The resistance value of the resistor R1 connected to the LED light source 130 is adjusted in such a way that effects are easily understood. Almost no current flows to the LED light source 140 until the switching element Q1 turns on, and it is therefore possible to ensure a greater difference in current between the LED light source 130 and the LED light source 140.

It should be noted that the quantities of LED packages included in the LED light source 130 and the LED light source 140, the series/parallel connection method therefor, and the like are not particularly restricted to the examples described above, and a single LED package may be used rather than a plurality thereof.

### <Second Embodiment>

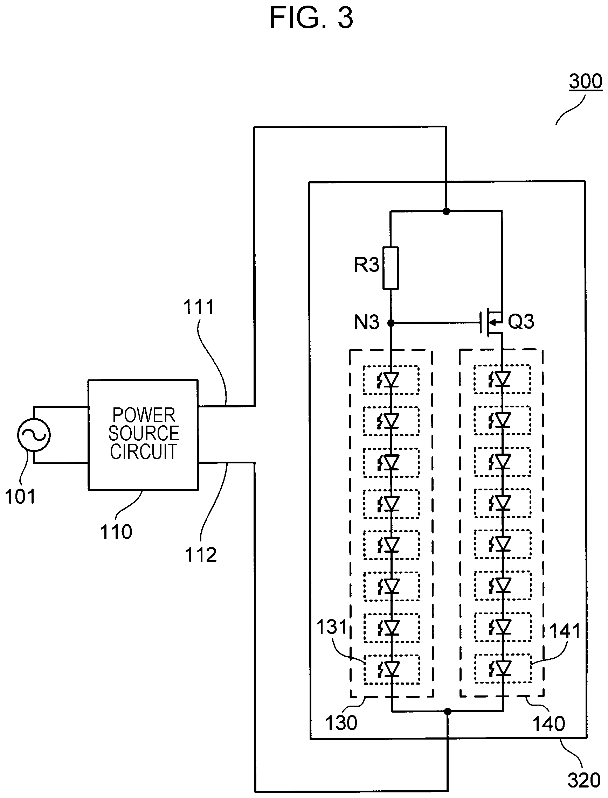

Next, an LED lighting device according to a second embodiment of the present invention will be described using Fig. 3. An LED lighting device 300 the configuration of which is depicted in Fig. 3 has a similar function to the LED lighting device 100 (Fig. 1, first embodiment). An irradiation unit 320 of the LED lighting device 300 has a different configuration from the irradiation unit 120 of the LED lighting device 100.

Similar to the irradiation unit 120, the irradiation unit 320 has the LED light source 130 and the LED light source 140. The irradiation unit 320 also has a resistor R3 that is connected in series to the anode side of the LED light source 130, and a switching element Q3 that is a P-channel MOS-FET connected in series to the anode side of the LED light source 140.

The operation when the driving current of the irradiation unit 320 is changed is substantially similar to that of the irradiation unit 120. The resistor R3 and the switching element Q3 for controlling current are connected to the anode side, and therefore a P-channel type of MOS-FET rather than an N-channel type is used for the switching element. When the voltage drop caused by the resistor R3 increases to a certain extent or more, the switching element Q3 turns on, and therefore the behavior is similar to that of the irradiation unit 120.

According to the aforementioned operation, similar to the LED lighting device 100, the LED lighting device 300 can also emit light at a low color temperature when the illuminance is low, and gradually emit light at a high color temperature as the illuminance increases.

### <Third Embodiment>

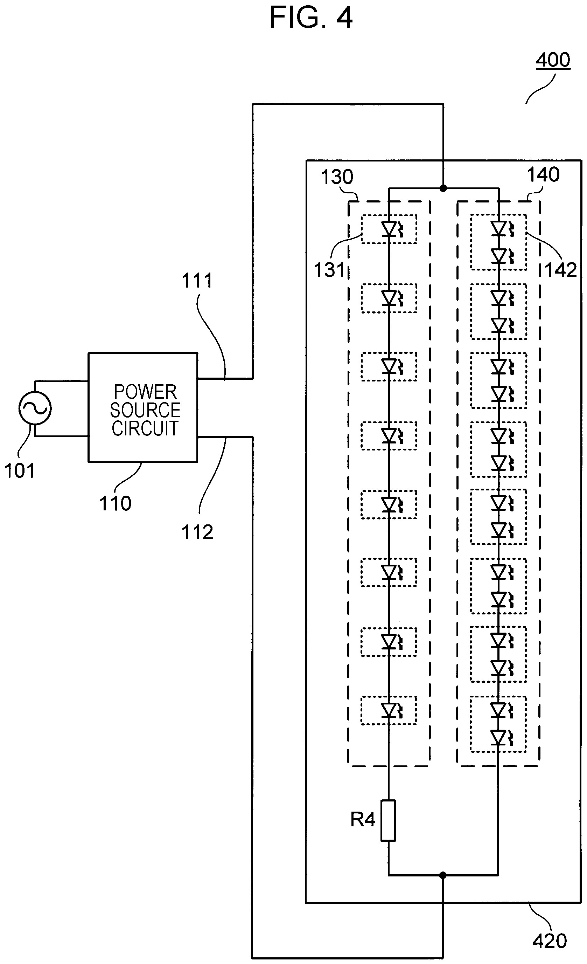

Next, an LED lighting device according to a third embodiment of the present invention will be described using Fig. 4.

In an LED lighting device 400 depicted in Fig. 4, LED packages 142 having two LED elements connected in series therein are used in the LED light source 140. In the LED light source 130 and the LED light source 140, the quantities of LED packages are the same (eight as an example in Fig. 4); however, the quantities of the LED elements connected in series are different, and therefore the forward voltage is different. A resistor R4 is connected to the LED light source 130, which has a low forward voltage. This irradiation unit is equivalent to the LED lighting device 1100 (Fig. 11) in terms of circuitry apart from the quantity of LEDs, and therefore, with the same scheme, the ratio of the current that flows to the LED light source 130 changes in accordance with the driving current that flows to an irradiation unit 420, and the color temperature of the emitted light changes. In other words, it is possible to cause the color temperature to change in accordance with illuminance.

### <Fourth Embodiment>

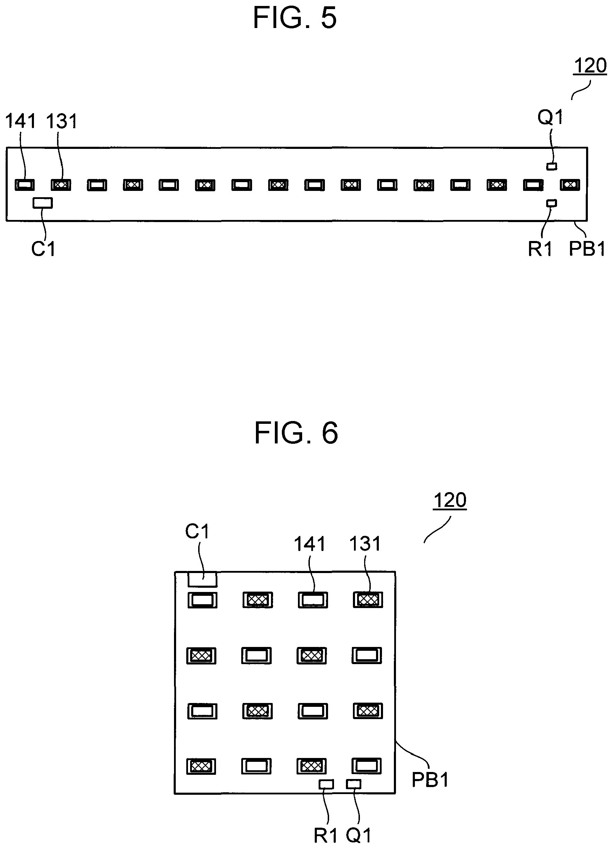

An LED substrate of an LED lighting device according to the present invention will be described using Figs. 5 and 6.

Fig. 5 depicts a schematic diagram of an LED substrate corresponding to the irradiation unit 120 (Fig. 1, first embodiment). In the LED substrate depicted in Fig. 5, eight LED packages 131, eight LED packages 141, the resistor R1, and the connector C1 are mounted on a printed substrate PB1. The LED packages 131 and the LED packages 141 are mounted equally in an alternating manner, and therefore color irregularities and luminance irregularities can be suppressed to the minimum. Furthermore, the work for connecting an anode and cathode can be easily performed by merely inserting a harness into the connector C1. An LED substrate depicted in Fig. 6 also has a configuration similar to that in Fig. 5; however, the LED packages 131 and the LED packages 141 are arranged in a staggered manner. Thus, surface irradiation is possible with a single substrate, and color irregularities can be suppressed to the minimum by implementing an equally staggered arrangement.

In the LED substrate depicted in Fig. 5, the quantities of the LED packages 131 and LED packages 141 are the same, and therefore the LED packages arranged at both ends are different. Consequently, when a plurality of these LED substrates are arranged horizontally side-by-side, different LEDs are arranged at the boundaries between adjacent substrates, and color irregularities are unlikely to occur. By arranging a plurality of LED substrates side-by-side in this way, a longer linear light source can be obtained while suppressing the occurrence of color irregularities. Furthermore, in the case where these LED substrates are arranged vertically side-by-side to obtain surface irradiation, the LED packages 131 and LED packages 141 of adjacent substrates may be swapped around. In this way, two types of LED packages can be arranged in a staggered manner. This kind of configuration is possible since the quantities of the LED packages are the same.

When a plurality of the LED substrates depicted in Fig. 6 are arranged vertically and horizontally side-by-side, the substrate boundaries also form an arrangement in which two types of LED packages are staggered. Consequently, considerable surface irradiation can be obtained by merely arranging the same substrates side-by-side. In the case where the quantities of the two types of LED packages are different, invariably there are portions where a staggered arrangement is not achieved, which therefore causes color irregularities. However, if the quantities of the two types of LED packages are the same, a staggered arrangement can be achieved, and therefore color irregularities are unlikely to occur.

Color irregularities are unlikely to occur even when a plurality of the LED substrates depicted in Figs. 5 and 6 are arranged side-by-side vertically and/or horizontally. When a plurality of substrates are used, control is possible not only by means of a method in which driving is performed separately from the power source circuit 110 (Fig. 1) but also by connecting a plurality of irradiation units 120 in parallel or in series.

Furthermore, this kind of LED substrate can be realized with the irradiation unit 320 (Fig. 3, second embodiment) or the irradiation unit 420 (Fig. 4, third embodiment) in exactly the same manner as with the irradiation unit 120.

### <Others>

Embodiments of the present invention have been described hereinabove; however, the scope of the present invention is not restricted thereto, and it is possible for various alterations to be added and carried out without deviating from the gist of the present invention.

For example, in the embodiments of the present invention described hereinabove, the two types of LED light sources each had LED packages connected in one line; however, a similar effect can be obtained even if a plurality of lines are connected in parallel. By adjusting the quantity of lines, it is possible to adjust the overall light emission intensity of the LED light sources.

Furthermore, in the aforementioned lighting device of the first or second embodiment, another resistor may be additionally added and connected in series to the resistor that is connected in series to the LED light sources. According to this kind of configuration, it is possible to alter the change in the proportion of current that flows to the LED light sources after the switching element has turned on.

Furthermore, in the aforementioned lighting device of the first or second embodiment, it is possible for the locations where the switching element and the resistor are inserted and the voltage that controls the switching element to be changed within the path along which each thereof is connected in series. If this kind of configuration is adopted, there is an improvement in the degree of freedom with respect to component arrangement when these elements are arranged on a printed substrate.

Furthermore, in the aforementioned lighting device of the first or second embodiment, the quantities of the LED packages in the LED light source 130 and the LED light source 140 may be different. Furthermore, in the aforementioned lighting device of the first or second embodiment, similar to the lighting device of the aforementioned third embodiment, LED packages having different quantities of LED elements connected in series may be used. These can be decided taking into consideration the voltage and current required to drive the irradiation unit, the change in the proportion of current that flows to the LED light sources, the arrangement of the LED packages, and the like.

Furthermore, for the switching element used in the present invention, it is possible to use an element other than the N-channel MOS-FET or the P-channel MOS-FET described as examples. For example, in the case where a junction FET or a relay is used, a similar function can be realized in a circuit configuration similar to that of a MOS-FET. Furthermore, it is also possible to use a bipolar transistor or a photocoupler. In addition, it is also possible to use a thyristor or a triac, and in these cases, lighting devices having different feelings of use can be realized.

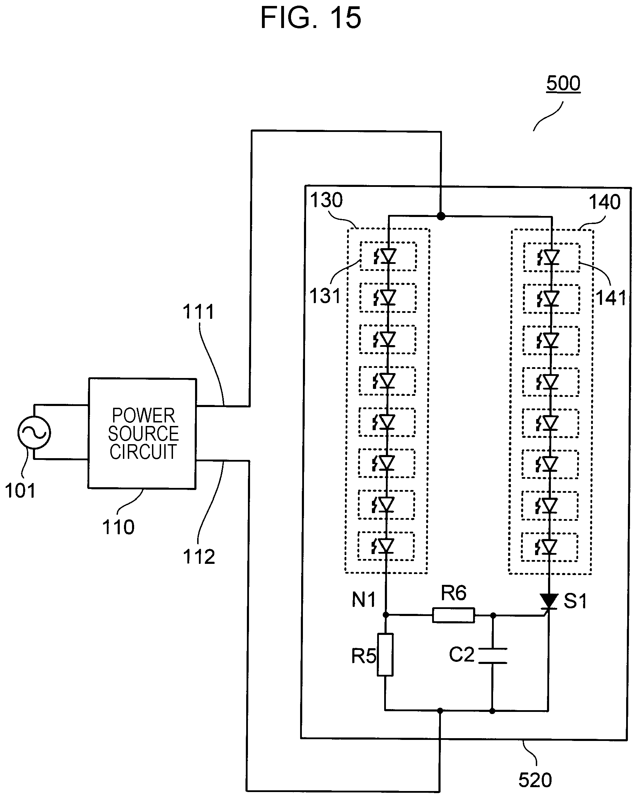

An LED lighting device 500 depicted in Fig. 15 is an example of a circuit configuration in which a thyristor is used as a switching element. A thyristor S1 is prevented from turning on due to minute fluctuations in gate voltage such as noise, and therefore fluctuations in voltage and current are controlled with the addition of a resistor R6 and a capacitance C2.

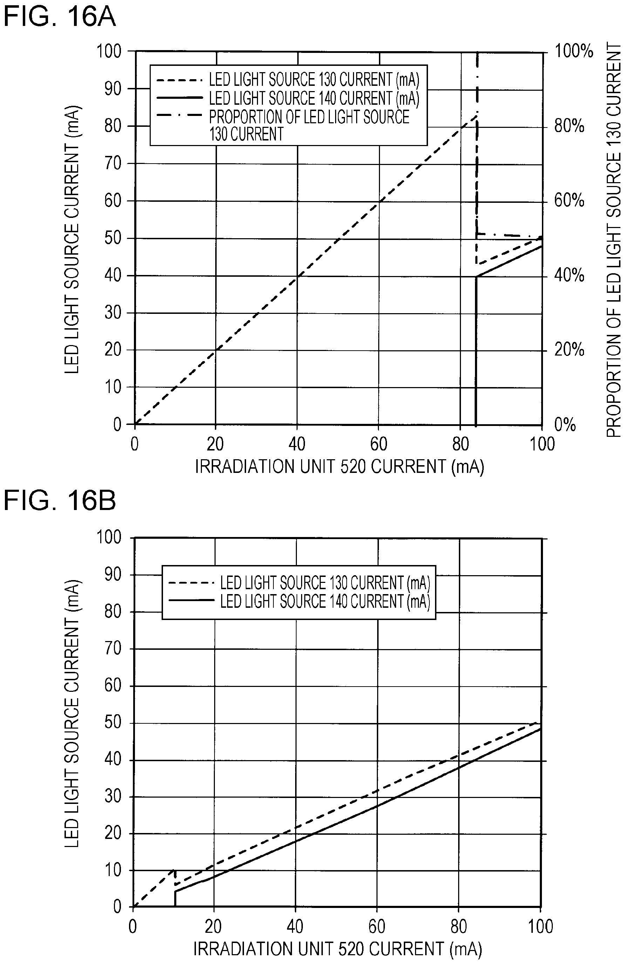

Fig. 16 constitutes simulation results indicating examples of the behavior of an LED lighting device 500. Fig. 16A constitutes behavior in the case where current is increased from a state in which the lighting is off. First, the potential of the node N1 is equal to a cathode voltage 112 and therefore the thyristor S1 is off, and consequently all of the current of an irradiation unit 520 flows to the LED light source 130 without current flowing to the LED light source 140. When the current of the LED light source 130 increases to a certain extent, the current of a resistor R5 also increases, and therefore the potential of the node N1 rises. The node N1 is connected to the gate of the thyristor S1 by way of the resistor R6, and therefore when the potential of the node N1 rises to a certain extent, the gate current of the thyristor S1 increases and the thyristor S1 turns on. The thyristor S1 continues to be on until the current is interrupted, and therefore current flows to both the LED light source 130 and the LED light source 140 in this state.

Fig. 16B constitutes simulation results for when the current of the irradiation unit 520 is gradually decreased from a state in which the thyristor S1 is on. First, the thyristor S1 is in an on state; however, when the current of the irradiation unit 520 decreases, the current of the LED light source 130 and the LED light source 140 also decreases. When the current of the LED light source 140, in other words, the anode current of the thyristor S1, is equal to or less than the holding current, the thyristor S1 turns off. Thus, all of the current of the irradiation unit 520 flows to the LED light source 130.

Owing to the aforementioned operation, from a state in which the LED lighting device 500 is off, first, current passes to only the LED light source 130, and when this current increases to a certain extent, current also flows to the LED light source 140, and therefore the color temperature changes drastically. Conversely, when the current of the irradiation unit is decreased, up to a certain point the LED light source 140 also passes current and therefore the color temperature does not change very much; however, when the current of the irradiation unit has decreased to a certain extent, switching is performed in such a way that current is no longer passed to the LED light source 140 and current is passed only to the LED light source 130, and therefore the color temperature changes drastically. In this way, by implementing a lighting device which has color temperature characteristics that exhibit hysteresis with respect to increases/decreases in current, it is possible to realize, with a simple circuit configuration, behavior in which a plurality of color temperatures are switched discretely.

In addition, in the LED lighting device 500, by deliberately causing the forward voltages of the LED light source 130 and the LED light source 140 to be significantly different, for example, it is possible to adjust the balance between the current passed by the LED light source 130 and the LED light source 140. When the forward voltage of the LED light source 140 becomes sufficiently lower than the forward voltage of the LED light source 130, for example, behavior occurs in which for the most part only the LED light source 130 is lit when the thyristor is off, and for the most part only the LED light source 140 is lit when the thyristor is on.

By implementing the configuration of the LED light sources of the configuration according to the present invention as a nested structure, it is possible to realize changes in a wide variety of color temperatures. It is also possible for the configurations of lighting devices according to the present invention having different behaviors as in the LED lighting device 500 and the LED lighting device 100, for example, to be mixed. If the LED light source 130 of the LED lighting device 500 is made to have a configuration such as that of the irradiation unit 120 exemplified in the LED lighting device 100 rather than an LED arrangement having a single color temperature, a behavior is exhibited in which the color temperature changes according to the current value even in a region in which only the LED light source 130 of the LED lighting device 500 is lit. By implementing a configuration having a similar nested structure and using a thyristor as the switching element, it is also possible for three or more types of color temperature to be made to change discretely in accordance with current. It goes without saying that it is also possible for the structure of the irradiation unit of the present invention and the structure of an irradiation unit according to conventional technology (for example, the structure of the irradiation unit 920 indicated in the LED lighting device 900) to be nested and combined.

Furthermore, only a configuration having components mounted on a printed substrate is exemplified as an irradiation unit hereinabove; however, by providing some of the components within a power source, for example, components having comparatively large dimensions can also be used without giving consideration to optical hindrance. Furthermore, by mounting at least some of the components other than the LEDs making up the irradiation unit in the same package as the LEDs, it is possible to simplify the configuration and to realize a lighting device that is easily assembled.

### Reference Signs List

100, 300, 400, 500 LED lighting device (the present invention)
700, 900, 1100 LED lighting device (conventional)
101 Alternating-current power source
110 Power source circuit
111 Anode line
112, 113 Cathode line
120, 320, 420, 520, 720, 920, 1120 Irradiation unit
130, 140 LED light source
131, 141, 142 LED packages
R1, R3, R4, R5, R6, R9, R11 Resistor
Q1, Q3 Switching element
C1, C2, C11 Connector
PB1, PB11 Printed substrate
S1 Thyristor

## Claims

1. A lighting device **characterized by** having:
a first light source including at least one first light-emitting unit having a first light emission color;
a second light source including at least one second light-emitting unit having a second light emission color;
a resistor connected in series to the first light source; and
a switching element connected in series to the second light source,
current flowing to the first light source being converted into a control voltage by the resistor, and
current flowing to the switching element being controlled by the control voltage.

2. The lighting device according to claim 1, **characterized in that** a field-effect transistor is used as the switching element.

3. The lighting device according to claim 1 or claim 2, **characterized in that** the first light source, the second light source, the resistor, and the switching element are mounted on the same printed substrate.

4. The lighting device according to any one of claim 1 to claim 3, **characterized in that** a plurality of irradiation units including the first light source, the second light source, the resistor, and the switching element are connected in series or parallel.

5. A lighting device **characterized by** having:
a first light source including at least one first light-emitting unit having a first light emission color;
a second light source including at least one second light-emitting unit having a second light emission color; and
a resistor connected in series to the first light source,
the first light-emitting unit and the second light-emitting unit being formed by different quantities of light-emitting elements being connected in series.
